# EUROPÄISCHE PATENTSCHRIFT

(11) **EP 4 102 723 B1**
(45) Veröffentlichungstag und Bekanntmachung des Hinweises auf die Patenterteilung: **02.07.2025**
(21) Anmeldenummer: 22172422.2
(22) Anmeldetag: 10.05.2022
(51) Int. Cl.: H03K 17/95

(54) **NÄHERUNGSSENSOR**
PROXIMITY SENSOR
CAPTEUR DE PROXIMITÉ

(30) Priorität: 10.06.2021 DE 102021114948
(43) Veröffentlichungstag der Anmeldung: 14.12.2022
(73) Patentinhaber: Turck Holding GmbH, 58553 Halver (DE)
(72) Erfinder: Faber, Michael, 58762 Altena (DE); Brauner, Karel, 58553 Halver (DE)
(74) Vertreter: DTS Patent- und Rechtsanwälte PartmbB

(56) Entgegenhaltungen:
- WO-A1-2020/208986
- DE-A1- 2 356 783
- DE-B3- 102012 214 330
- DE-C1- 3 730 113

## Beschreibung

Die vorliegende Erfindung betrifft einen Näherungssensor nach dem Oberbegriff des Anspruchs 1.

Induktiv arbeitende Näherungssensoren sind im Stand der Technik bekannt, so offenbart die US 8 188 730 B2 ein Spulensystem mit zwei Spulen, welche im einen Ferritkern angebracht sind. Aus der US 5 952 822 A ist ein Näherungssensor bekannt, bei dem eine Abschirmung der beiden Spulen mittels eines flächigen Elements einseitig, zweiseitig oder dreiseitig vorgeschlagen wird. Weiterhin offenbart die WO 2016/037597 A1 eine elektrisch leitfähige Abschirmung der Spulen eines Näherungssensors, bei welcher ein Abschirmbecher vorgesehen wird, der die Spulenanordnung seitlich und auf der hinteren Seite umgibt, wobei der Abschirmbecher in einen oberen Flansch übergeht. Schließlich ist auch aus der DE 10 057 773 A1 eine Ausführung eines Näherungssensors bekannt geworden, bei welcher zur Erweiterung des Näherungsfeldes die Sekundärspulen in mehrere in derselben Ebene angeordnete Teilspulen aufgeteilt ist, wobei die Abschirmung der Primärspule symmetrisch zwischen den Sekundärspulen liegt. Aus der DE 2 356 783 A1 und DE 10 2012 214 330 B3 sind Näherungssensoren bekannt.

Insgesamt ist nach wie vor Verbesserungsbedarf hinsichtlich Erfassungs- und Schaltabstand von Näherungssensoren gegeben, bei gleichzeitig sehr kompakter und wirtschaftlicher Bauweise. Insbesondere ist es ein regelmäßiges Problem, dass die Einbausituation eines Näherungssensors, durch den Einsatz von metallischen Befestigungs- oder Abdeckungselementen zu einer partiellen Abschirmung und damit zur Veränderung der Schalteigenschaften des Sensors führt. Es ist somit die Aufgabe der vorliegenden Erfindung, einen Näherungssensor vorzuschlagen, der einen erhöhten Schaltabstand hat, bei verbesserten Einbaueigenschaften und welcher konstruktiv einfach aufgebaut ist.

Die Primär- oder Sendespule und die mindestens eine Sekundärspule sind in Richtung der Achse voneinander geringfügig beabstandet. Idealerweise sind bei gewickelten Spulen, diese in Rillen oder Vertiefungen geführt oder durch umlaufende Stege voneinander definiert beabstandet angeordnet. Der Spulenträger weist eine Stirnfläche und eine Fußfläche auf, wobei die Stirnfläche des Spulenträgers der inneren Oberfläche der Frontkappe unmittelbar gegenüber liegt und/oder an dieser anliegt. Idealerweise ist die Stirnfläche des Spulenträgers mit der Frontkappe verbunden, verschweißt oder verklebt. Die erste Sekundärspule ist hierbei in Achsrichtung näher an der Stirnfläche beziehungsweise unmittelbar angrenzend, die Primärspule näher an dem Fußende angeordnet.

Der Spulenträger ist aus einem nichtleitenden Material, welches einen geringen Ausdehnungskoeffizienten über den Temperaturbereich aufweist. Insbesondere ist der Spulenträger aus einem glasfaserverstärkten Kunststoffe und/oder einem Epoxidharze hergestellt.

Kern der Erfindung besteht darin, dass eine zweite Sekundärspule am Spulenträger vorgesehen ist, die gegenläufig gewunden oder gewickelt ist, und wobei die Primärspule zwischen den beiden Sekundärspulen angeordnet ist. Weiterhin ist mindestens im Achsbereich der zweiten Sekundärspule und diese umschließend ein metallisches Abschirmelement angeordnet, und im Achsbereich der ersten Sekundärspule, die direkt an die Stirnfläche oder einer Verschlusskappe angrenzt, kein metallisches Abschirmelement vorgesehen.

Hierbei ist mit Achse oder Achsrichtung die theoretische, zentrale (Symmetrie-)Achse gemeint, die durch die (gedruckten) Windungen oder Wicklungen der Spulen und/oder die Geometrie des Spulenträgers definiert wird.

Bei einer vorteilhaften Ausführungsform weist das metallische Abschirmelement eine Breite auf, die mindestens einem Viertel der Höhe zwischen der zweiten Sekundärspule und der inneren Oberfläche der Frontkappe entspricht, idealerweise entspricht die Breite mindestens der Hälfte der Höhe. Das Abschirmelement überragt die zweite Sekundärspule somit in Achsrichtung wesentlich, ohne in den Erfassungsbereich der ersten Sekundärspule hineinzuragen, wodurch optimal Schalteigenschaften erreicht werden.

Ein vorteilhaftes Verhältnis zwischen der Höhe des Spulenaufbaus und der Breite des Abschirmelementes ist gegeben, wenn die Breite 30% bis 50% der Höhe des Spulenaufbaus entspricht.

Eine weitere Verbesserung besteht darin, dass das Abschirmelement eine Breite aufweist, so dass in Achsrichtung auch die Primärspule mindestens teilweise abgeschirmt wird, insbesondere vollständig abgeschirmt wird. Je nach gewünschter Schaltcharakteristik beisteht eine Verbesserung darin, wenn die Breite des Abschirmelements größer ist als der äußere Abstand der Spulen und/oder nur in Achsrichtung-zur ersten Sekundärspule hin den jeweiligen Spulenrand überragt. Dabei sollte das Abschirmelement insbesondere nicht in den Achsbereich der vorderen, ersten Sekundärspule ragen, um deren Erfassungsradius nicht nachteilig einzuschränken.

Es erfolgt somit eine partielle Abschirmung von Spulen des gewickelten oder gedruckten Mehrfachspulensystems des induktiven Näherungssensors, indem mindestens eine der zur Signalerzeugung und/oder -auswertung verwendete Spule abgeschirmt wird. Hierdurch kann der Näherungssensor bei einem hohen, nichtbündigen Schaltabstand, trotzdem bündig in eine metallische Umgebung auf- und eingebaut werden. Ein üblicher Einbauzustand wird durch die umlaufende Abschirmung simuliert, so dass das Verhalten des Näherungssensors in einer "schlechtesten" späteren Einbausituation schon herstellungsseitig simuliert wird und laborseitig vermessen werden kann.

Durch diesen Aufbau wird erreicht, dass die interne partielle Abschirmung des Mehrfachspulensystems bezüglich der Lage zu den Einzelspulen durch das Distanzstück genau in die optimale axiale Position gesetzt wird. Somit wird mit dem ausgewählten optimalen Spulendurchmesser, die sich bildenden Differenzspannung im eingestellten Schaltpunkt genullt. Einflüsse durch metallische Elemente der Einbausituation werden somit weitgehend ausgeschaltet und ein hoher Schaltabstand wird erreicht.

Der Vorteil besteht somit darin, dass die erste Sekundärspule in unmittelbarer, maximaler Nähe zum Erfassungsbereich angeordnet werden kann, so dass ein weiter Radius überwacht und detektiert wird, während die Einflüsse von der und auf die zweite Sekundärspule und gegebenenfalls die Primärspule so gering wie möglich gehalten werden. Auf diese Weise wir eine sehr hohe Erfassungspräzision und Unanfälligkeit bezüglich äußerer Störeinflüsse erreicht.

Eine verbesserte Ausführung besteht darin, das Abschirmelement an der die zweite Sekundärspule oder das Paar aus zweiter Sekundärspule und der Primärspule umschließenden Innenwand des Gehäuses und/oder der umschließenden Kappeninnenwand mindestens abschnittsweise anzulegen, so dass auch für unterschiedliche Spulendurchmesser, die abhängig von den jeweiligen Detektionsaufgaben dimensioniert werden, weitestgehend ein und dasselbe Gehäuse und Abschirmelement vorsehen zu können. Es ist dabei vorteilhaft, den maximal möglichen Abstand des Abschirmelementes zu insbesondere der zweiten Sekundärspule vorzusehen, indem diese beispielsweise an der Innenwand des Gehäuses oder der Frontkappe anliegt, wobei der Durchmesser der zweiten Sekundärspule 60% bis 70% des Durchmessers des Abschirmelementes betragen sollte.

Bei einer verbesserten Variante ist zwischen der inneren Oberfläche der Frontkappe und dem Abschirmelement mindestens ein nicht-metallischer, ein- oder mehrteiliger Distanzkörper angeordnet, auf welchem das Abschirmelement mindestens abschnittsweise aufliegt und/oder von welchem es getragen. Hierdurch lassen sich sehr leichtmontierbare und kostengünstige Varianten von Näherungssensoren mit unterschiedlichen Spulenanordnungen herstellen, bei denen die präzise Abschirmung der Primärspule sehr einfach angepasst werden kann. Idealerweise ist der Distanzkörper ein Ring oder Kranz, der vorteilhafterweise monolithisch aus Kunststoff hergestellt ist.

Eine vorteilhafte Ausführungsform besteht darin, dass der Spulenträger ringförmig ausgeführt ist und hierdurch einen freien Kern und eine Innenwand aufweist. Hierbei meint ringförmig jede länger gestreckte hohle Form, wie auch ein Rohrstück mit einem beliebigen Querschnitt, der idealerweise allerdings rund ist. Die Ringdicke in Umlaufrichtung und/oder Achsrichtung kann dabei variieren. Kern dieser Ausführungsform ist ein Trägerelement, an welchem die Leiterplatte direkt oder mittelbar befestigt ist. Das Trägerelement weist hierbei einen Führungs- und Halteabschnitt auf, mit welchem es an der Innenwand des Spulenträgers anliegt und/oder worüber es befestigt ist. Auf diese Weise ist eine sehr kompakte und stabile Bauform geschaffen, mit einer sehr guten Verbindung zwischen dem Spulenträger und der Leiterplatte bzw. der Prozess- und Empfangseinheit. Insbesondere kann dieses allseits zugänglich einfach vormontiert und im Anschluss in das Gehäuse und/oder auf die Frontkappe eingesetzt werden.

Eine weiter Verbesserung besteht darin, dass die Leiterplatte mit einem Steckerelement verbunden ist oder ein solches aufweist, über welches der Näherungssensor daten- und/oder stromleitend mit externen Strukturen verbunden werden kann. Solche externen Strukturen sind in der Regel Daten- und/oder Stromkabel, die zu Komponenten eines Netzwerkes, insbesondere eines Ethernets, eines BUS-Systems, I/O-Link oder dergleichen führt. Vorteilhafterweise weist das Steckerelement eine Gruppe aus zwei oder mehr nebeneinander angeordneten Einzelsteckern auf, wobei die Einzelstecker idealerweise parallel zur Achse ausgerichtet sind.

Die Verbindung von Leiterplatte und Spulenträger des Näherungssensors kann weiter verbessert werden, wenn das Steckerelement mindestens abschnittsweise auf der Fußfläche des Spulenträgers aufliegt und hierbei den ringförmigen Spulenträger überbrückt und/oder das Steckelement auf einem Stegelement des Trägerelements aufliegt beziehungsweise hierauf befestigt ist, und dieses Stegelement mindestens abschnittsweise auf der Fußfläche des Spulenträgers aufliegt und den ringförmigen Spulenträger teilweise überbrückt. Der Vorteil dieser Konstruktion ist eine sehr stabile Auflage des Steckerelements bei geringstmöglichem Bauraum. Die nötige Kraft beim Anbringen eines verbindenden Gegensteckers kann auf die Frontkappe in gerader Linie abgeleitet werden, wodurch der Zusammenbau sehr erleichtert wird.

Weitere Einzelheiten und Vorteile der Erfindung sollen nun anhand von in den Zeichnungen dargestellten Ausführungsbeispielen näher erläutert werden.

Es zeigen:
- Fig. 1: einen Näherungssensor als vertikale Schnittdarstellung,
- Fig. 2: den Näherungssensor aus Figur 2 als horizontale Schnittdarstellung,
- Fig. 3: eine Explosionszeichnung des Sensors nach Figur 1 und 2,
- Fig. 4: eine vertikale Schnittdarstellung eines weiteren Näherungssensors mit drei Spulen,
- Fig. 5: eine vertikale Schnittdarstellung eines weiteren Näherungssensors mit gedruckten Sekundärspulenspulen und einer gewickelten Primärspule und
- Fig. 6: eine vertikale Schnittdarstellung einer weiteren Ausführungsform eines Näherungssensors mit drei gedruckten Spulen.

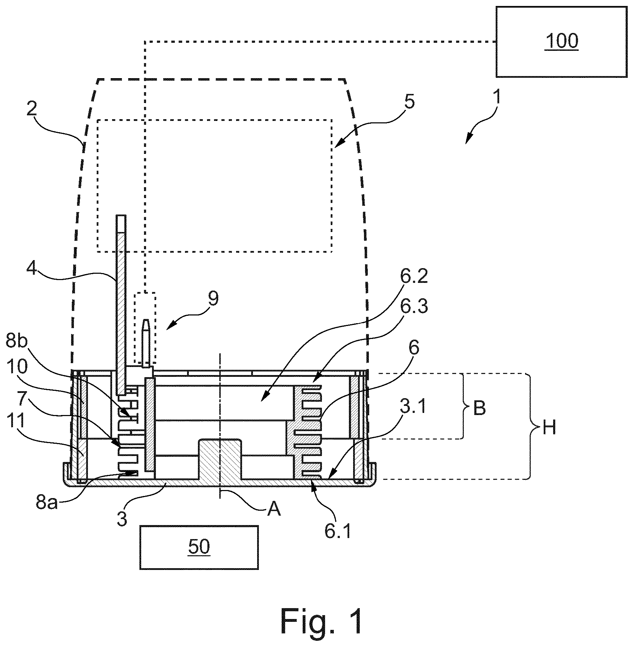

Der in Figur 1 gezeigte Näherungssensor 1 ist vertikal nach unten ausgerichtet. Das als gestrichelte Linie skizzierte Gehäuse 2 weist am unteren Ende eine Frontkappe 3 auf, auf welchem zentral der Spulenträger 6 angebracht ist, der mit seiner Stirnfläche 6.1 mit der inneren Oberfläche 3.1 der Frontkappe 3 planparallel anliegt und verklebt ist, oder in nicht dargestellter Weise form- und/oder kraftschlüssig befestigt ist. In parallelen Rillen oder Nuten des Spulenträgers 6 sind mindestens eine obere, erste Sekundärspule 8a und eine zweite, untere Sekundärspule 8b angeordnet. Zwischen diesen beiden Sekundärspulen 8a, b, die gegenläufig orientierte Wicklungen aufweisen, ist eine Primärspule 7 (Sendespule) eingebracht. Hierbei sind die Lageangaben mit Bezug auf die Schwerkraft, wie insbesondere "oben" oder "unten" nicht einschränkend zu verstehen und dienen nur zur Verdeutlichung anhand der jeweiligen Darstellung. Es versteht sich, dass der Näherungssensor 1 eine beliebige Ausrichtung haben kann, wie beispielsweise horizontal zur Seite, gekippt, nach oben oder nach unten, so dass die hierin gegeben Angaben dann analog zu verstehen sind.

Der Spulenträger 6 ist monolithisch als Ring oder Kranz ausführt und erstreckt sich in Richtung der (Symmetrie-)Achse A, um die auch die Sekundärspulen 8a, b und die Primärspule 7 konzentrisch angeordnet sind. Der Spulenträger 6 ist hinsichtlich der erforderlichen Spulendurchmesser optimiert und weist hierzu in Achsrichtung A Abschnitte mit unterschiedlichen, freien Innendurchmessern auf, so dass die Innenfläche 6.2 unterschiedliche Ringe oder Ringkonturen aufweist. Auf der Außenseite sind unterschiedlich tiefe, umlaufende Rillen oder Nuten angeordnet, in welchen unter anderem auch die Primärspule 7 und die Sekundärspulen 8a, b auf- oder eingebracht sind. Die Funktionsweise und Wechselwirkung der angeregten Spulen bei der Erfassung eines Objekts 50, das vor der freien Seite des Näherungssensors 1 erscheint, ist dem Fachmann dem Grunde nach bekannt und wird daher nicht näher beschrieben.

Auf der Fußfläche 6.3 des Spulenträgers 6 ist ein Steckerelement 9 aufgelegt, dessen Einzelstecker parallel zur Achsrichtung A ausgerichtet sind, so dass kein zusätzlicher Bauraum verbraucht wird und vertikale Kräfte über den Spulenträger 6 auf die Frontkappe 3 abgeleitet werden. Dieses mit einer Leiterplatte 4 verlötete Steckerelement 9 kann mit einer externen Steuer- und Auswerteeinheit 100 verbunden werden. Hierbei soll unter Steuer- und Auswerteeinheit 100 jegliche externen Komponenten und/oder Netzwerk verstanden werden, mit dem der Näherungssensor 1 strom- und/oder datenleitend verbindbar ist.

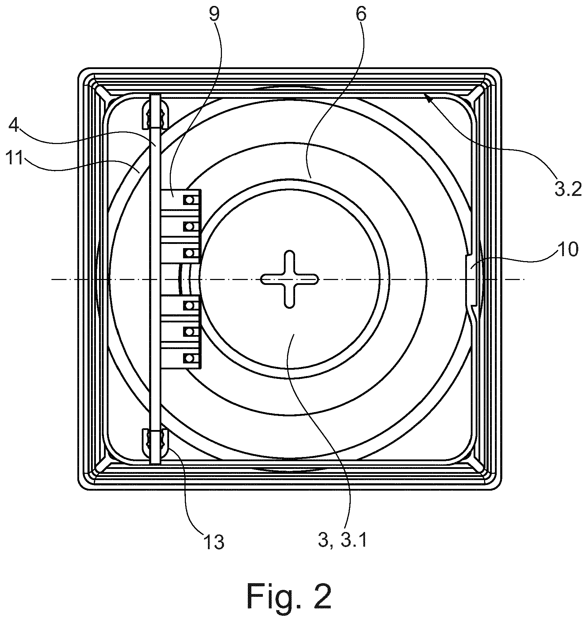

Das aus Kupfer hergestellte Abschirmelement 10 weist eine Breite B auf und ist umschließend auf der Höhe der der Primärspule 7 und der unteren, zweiten Sekundärspule 8b angeordnet, indem es auf einen als Kunststoffring ausgeführten Distanzkörper 11 aufgelegt ist. In dem gezeigten Ausführungsbeispiel der Figuren 1 bis 4, beträgt das Verhältnis zwischen der Breite B des Abschirmelementes und der Höhe H des Spulenaufbaus 45%, weiterhin ist der Durchmesser des Abschirmrings 10 um 1/3 größer als der Durchmesser der zweiten Sekundärspule 8b. Figur 2 zeigt den Näherungssensor 1 nach Figur 1 als vertikale Schnittdarstellung. Zu erkennen ist, dass das Abschirmelement 10 als viereckiger Rahmen ausgeführt ist, welcher an der den Spulenträger 6 umschließenden Innenwand 3.2 der Frontkappe 3 anliegt und von dem runden Distanzkörper 11 in der nötigen Achsenlage gehalten wird. Die Leiterplatte 4 ist in Richtung der Achse A in der Länge orientiert und über das verlötete Steckerelement 9 auf der Fußfläche 6.3 aufgelegt. Zusätzlich ist die Leiterplatte 4 in seitlichen Führungen 13 eingebracht und gehalten, die Teile der Frontkappe 3 sind. Gut zu erkennen ist die kompakte Bauform und gute Zugänglichkeit des Steckerelements 9 bei geöffnetem Gehäuse 2.

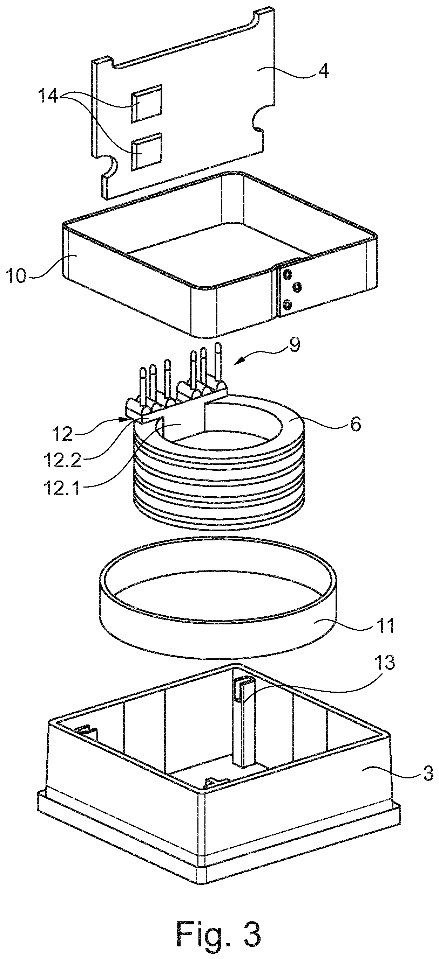

Figur 3 zeigt den Näherungssensor 1 nach den Figuren 1 und 2 als Explosionsdarstellung, so dass die vorherigen Ausführungen analog gelten. In der Darstellung nach Figur 3 ist zu erkennen, dass ein Trägerelement 12 vorgesehen ist, welches am unteren Ende einen Führungs- und Halteabschnitt 12.1 aufweist und ein oberes Ende, das als Stegelement 12.2 ausgebildet ist. Auf dem Stegelement 12.2, das auf der Fußfläche 6.3 des Spulenträgers 6 zur Auflage kommt und den freien Kern teilweise überbrückt, ist das Steckerelement 9 mit den sechs Einzelsteckern angebracht. Der Führungs- und Halteabschnitt 12.1 des Trägerelements 12 ragt in Achsenrichtung in den Kern des Spulenträgers 6 und liegt an dessen Innenfläche 6.2 an. In einer nicht gezeigten Varianten ist das Stegelement 12.2 und/oder der Führungs- und Halteabschnitt 12.1 mit dem Spulenträger 6 verrastet und/oder verklebt. Auf der Leiterplatte 4 sind zwei (mikro-)elektronische Bauteile 14 angedeutet, die beispielsweise ein µ-Controller, ein Speicherbaustein, ein ADC (Analog-Digital-Converter) oder dergleichen sein können.

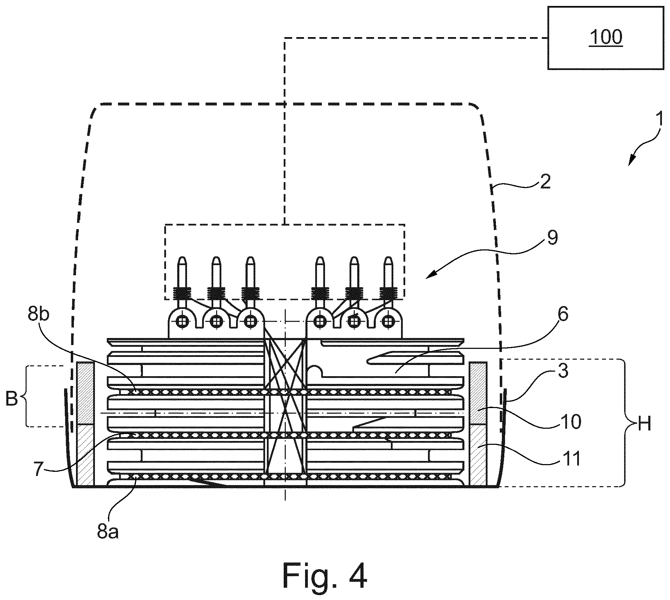

Fig. 4 zeigt einen Spulenträger auf dem die zwei Sekundärspulen 8a, b angeordnet sind, welche entgegengesetzte Wickelrichtung haben. Die Breite B des Abschirmelementes 10 ist derart, dass die Primärspule 7 und die zweite Sekundärspule 8b gemeinsam umrahmt und abgeschirmt werden, wobei das aus einem nicht schirmenden Kunststoff gefertigte Distanzelement 11 nur im Bereich der ersten Sekundärspule 8a angeordnet ist.

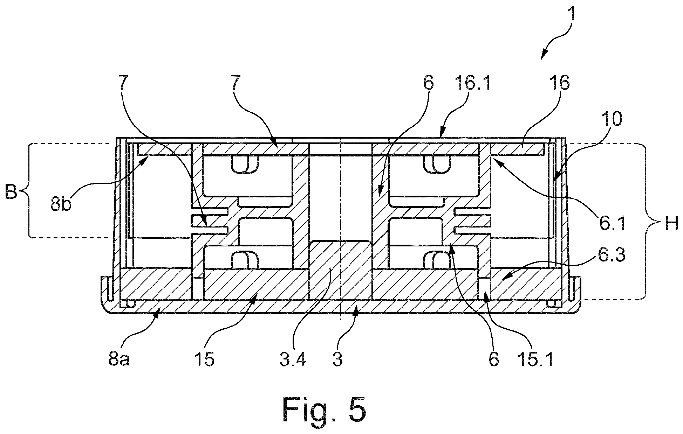

Bei der Ausführungsform nach Figur 5 ist die erste Sekundärspule 8a eine gedruckte Spule, die Teil einer auf der Stirnfläche 6.1 des Spulenträgers 6 befestigten ersten Leiterplatte 15 ist. Die zweite Sekundärspule 8b ist in analoger Weise aufgedruckt, als Teil einer auf der Fußfläche 6.3 befestigten zweiten Leiterplatte 16. Die Leiterplatten 15, 16 weisen Positionsbohrungen 15.1, 16.1 auf, in welche Aufnahmeelemente 6.4 des zentralen Spulenträgers 6 eingeführt und befestigt sind. In dem gezeigten Ausführungsbeispiel ist die Primärspule 7 in Rillen auf dem zentralen Spulenträger 6 gewickelt. Die Breite des Abschirmelements 10 überdeckt in Achsrichtung A die zweite Leiterplatte 16 mit der gedruckten, zweiten Sekundärspule 8b und die gewickelte Primärspule 7.

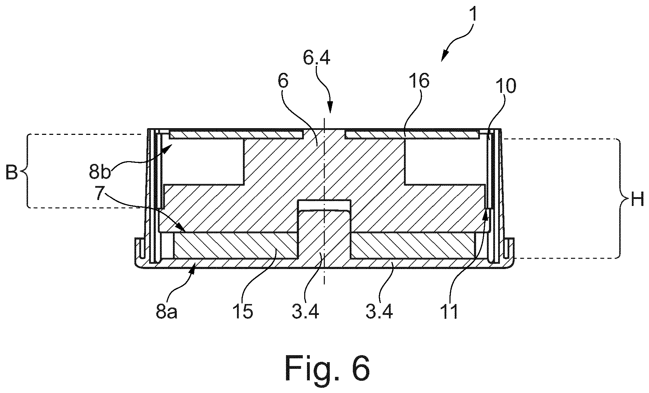

Die Positionsbohrungen 15.1, 16.1 in den Leiterplatten 15, 16 können jede geeignete Geometrie aufweisen, insbesondere auch als Rillen oder Nuten ausgebildet sein, wobei das jeweilige Aufnahmeelement 6.4 eine entsprechende, komplementäre Geometrie aufweist. In den Ausführungsformen nach den Figuren 5 und 6 weist die Frontkappe 3 ein Zentrierelement 3.4 auf, welches in eine komplementäre Aufnahmeöffnung sowohl der kopfseitigen ersten Leiterplatte 15 als auch des Spulenträgers 6 formschlüssig einführt und bedarfsweise verklebt oder befestigt ist.

Die Figur 6 zeigt eine vertikale Schnittdarstellung einer weiteren Ausführungsform eines Näherungssensors 1 mit drei gedruckten Spulen 7, 8a, 8b. Hierbei sind die erste Sekundärspule 8a und die Primärspule 7 auf einer gemeinsamen Leiterplatte 15 auf den jeweils gegenüberliegenden Oberflächen angeordnet, die analog zur Ausführungsform der Figur 5 auf der inneren Oberfläche 3.1 der Frontkappe 3 aufliegt und von einem zentralen Aufnahmeelement 3.4 durchdrungen und gehalten wird. Der Spulenträger 6 umfasst den Distanzkörper 11, der monolithisch als umlaufender Ring, Kante oder eine Vielzahl von Tragbolzen ausgebildet ist und auf dessen Oberkante das umlaufende Abschirmelement 10 gelagert ist. Die zweite Leiterplatte 16, auf welcher die zweite Sekundärspule 8b aufgedruckt ist, weist eine zentrale Positionsbohrung 16.1 auf, in welche ein zentrales Aufnahmeelement 6.4 des Spulenträgers 6 eingefügt ist. In beiden Ausführungsvarianten nach Figur 5 und 6 ist die Breite B 50% der Höhe H.

### Bezugszeichenliste

1 Näherungssensor
2 Gehäuse
3 Frontkappe
   3.1 Oberfläche
   3.2 Innenwand
   3.3 Zentrierelement
4 Leiterplatte
5 Prozess- und Empfangseinheit
6 Spulenträger
   6.1 Stirnfläche
   6.2 Innenfläche
   6.3 Fußfläche
   6.4 Aufnahmeelement
7 Primärspule (Sendespule)
8a Sekundärspule, erste
8b Sekundärspule, zweite
9 Steckerelement
10 Abschirmelement
11 Distanzkörper
12 Trägerelement
   12.1 Führungs- und Halteabschnitt
   12.2 Stegelement
13 Führungsnut
14 Bauteil, (mikro-)elektronisches
15 Leiterplatte, erste
   15.1 Positionsbohrung
16 Leiterplatte, zweite
   16.1 Positionsbohrung
50 Objekt
100 Steuer- und/oder Auswerteeinheit
A Achse
B Breite
H Höhe

## Patentansprüche

1. Näherungssensor (1) zur induktiven Erfassung von Objekten (50), umfassend
- ein Gehäuse (2) mit einer Frontkappe (3), welche die Erfassungsseite des Näherungssensors (1) bildet,
- eine eine Leiterplatte (4) umfassende Prozess- und Empfangseinheit (5), welche mit einer externen Steuer- und/oder Auswerteeinheit (100) verbindbar ist,
- wobei ein ein- oder mehrteiliger Spulenträger (6) vorgesehen ist, auf dem in Richtung der Achse (A) beabstandet mindestens eine Primärspule (7) und mindestens eine erste Sekundärspule (8a) umlaufend gewickelt oder gedruckt angeordnet sind, wobei eine Stirnfläche (6.1) des Spulenträgers (6) der inneren Oberfläche (3.1) der Frontkappe (3) unmittelbar gegenüber liegt und/oder an dieser anliegt, und die erste Sekundärspule (8a) in Achsrichtung näher an der Stirnfläche (6.1) liegt als die Primärspule (7), wobei eine zweite Sekundärspule (8b) am Spulenträger (6) vorgesehen ist, welche gegenläufig zur ersten Sekundärspule (8a) gewunden oder gewickelt ist, wobei die Primärspule (7) zwischen den beiden Sekundärspulen (8a, b) angeordnet ist, wobei ein metallisches Abschirmelement (10) so angeordnet ist, dass es die zweite Sekundärspule (8b) umschließt, und wobei das Abschirmelement (10) nicht in den Achsbereich der ersten Sekundärspule (8a) ragt, um deren Erfassungsradius nicht einzuschränken.

2. Näherungssensor (1) nach Anspruch 1, **dadurch gekennzeichnet, dass** das Abschirmelement (10) eine Breite aufweist, so dass in Achsrichtung auch die Primärspule (7) mindestens teilweise abgeschirmt wird, insbesondere vollständig abgeschirmt wird.

3. Näherungssensor (1) nach einem der Ansprüche 1 oder 2, **dadurch gekennzeichnet, dass** die Breite (B) des Abschirmelements (10) in Achsrichtung (A) auf die Frontkappe (3) mindestens Faktor 0,25 der Höhe (H) beträgt, wobei die Höhe (H) durch den Abstand der zweiten Sekundärspule (8b) von der inneren Oberfläche (3.1) der Frontkappe (3) gebildet wird, idealerweise die Breite (B) im Bereich von Faktor 0,3 bis 0,5 der Höhe (H) beträgt..

4. Näherungssensor (1) nach einem der vorherigen Ansprüche, **dadurch gekennzeichnet, dass** das Abschirmelement (10) an der die zweite Sekundärspule (8b) oder das Paar aus zweite Sekundärspule (8b) und Primärspule (7)
- umschließenden Innenwand (2.1) des Gehäuses (2) und/oder
- umschließenden der Kappeninnenwand (3.2)
mindestens abschnittsweise anliegt.

5. Näherungssensor (1) nach einem der vorherigen Ansprüche, **dadurch gekennzeichnet, dass** der Abschirmring (10) innen an der Frontkappe (3) anliegt, und wobei der Durchmesser der zweiten Sekundärspule (8b) Faktor 0,6 bis 0,7 des Durchmessers des Abschirmelementes (10) beträgt.

6. Näherungssensor (1) nach einem der vorherigen Ansprüche, **dadurch gekennzeichnet, dass** zwischen der inneren Oberfläche (3.1) der Frontkappe (3) und dem Abschirmelement (10) mindestens ein nicht-metallischer, ein- oder mehrteiliger Distanzkörper (11) angeordnet ist, wobei das Abschirmelement (10) auf diesem Distanzkörper (11) mindestens abschnittsweise aufliegt und/oder von diesem getragen wird.

7. Näherungssensor (1) nach einem der vorherigen Ansprüche, **dadurch gekennzeichnet, dass** der Distanzkörper ein Ring oder ein Kranz ist, insbesondere ein Kunststoffring oder -kranz.

8. Näherungssensor (1) nach einem der vorherigen Ansprüche, **dadurch gekennzeichnet, dass** der Spulenträger (6) ringförmig ausgeführt ist und eine Innenwand (6.2) aufweist, wobei ein Trägerelement (12) vorgesehen ist, an welchem die Leiterplatte (4) befestigt ist und das Trägerelement (12) mit einem Führungs- und Halteabschnitt (12.1) an der Innenwand (6.2) des Spulenträgers (6) anliegt und/oder hieran befestigt ist.

9. Näherungssensor (1) nach einem der vorherigen Ansprüche, **dadurch gekennzeichnet, dass** die Leiterplatte (4) mit einem Steckerelement (9) verbunden ist oder ein Steckerelement (9) aufweist, über welches der Näherungssensor (1) daten- und/oder stromleitend mit externen Strukturen verbunden werden kann.

10. Näherungssensor (1) nach Anspruch 9, **dadurch gekennzeichnet, dass** das Steckerelement (9) eine Gruppe aus zwei oder mehr nebeneinander angeordnete Einzelstecker (9.1 ... 9.n) aufweist, wobei die Einzelstecker (9.1 ... 9.n) parallel zur Achse (A) ausgerichtet sind.

11. Näherungssensor (1) nach einem der Ansprüche 9 oder 10, **dadurch gekennzeichnet, dass**
- das Steckerelement (9) mindestens abschnittsweise auf der der Stirnfläche (6.1) des Spulenträgers (6) entgegen gesetzten Fußfläche (6.3) aufliegt und den ringförmigen Spulenträger (6) überbrückt oder
- das Steckelement (9) auf einem Stegelement (12.2) des Trägerelements (12) aufliegt oder hierauf befestigt ist, welches mindestens abschnittsweise auf der Fußfläche (6.1) des Spulenträgers (6) aufliegt und den ringförmigen Spulenträger (6) überbrückt.

## Claims

1. Proximity sensor (1) for inductive detection of objects (50), comprising
- a housing (2) having a front cap (3) which forms the detection side of the proximity sensor (1),
- a processing and receiving unit (5) which comprises a printed circuit board (4) and which can be connected to an external control and/or evaluation unit (100),
- wherein a single-part or multi-part coil carrier (6) is provided, on which at least one primary coil (7) and at least one first secondary coil (8a) are arranged circumferentially wound or pressed and spaced apart in the direction of the axis (A), wherein an end surface (6.1) of the coil carrier (6) of the inner surface (3.1) of the front cap (3) is directly opposite and/or abuts against it, and the first secondary coil (8a) in the axial direction is closer to the end surface (6.1) than the primary coil (7), wherein a second secondary coil (8b) is provided on the coil carrier (6), which is wound in the opposite direction to the first secondary coil (8a), wherein the primary coil (7) is arranged between the two secondary coils (8a, b), wherein a metallic shielding element (10) is arranged in such a way that it encloses the second secondary coil (8b), and wherein the shielding element (10) does not extend into the axial area of the first secondary coil (8a) in order not to restrict its detection radius.

2. Proximity sensor (1) according to Claim 1, **characterized in that** the shielding element (10) has a width such that the primary coil (7) is also at least partially shielded, in particular is completely shielded, in the axial direction.

3. Proximity sensor (1) according to either one of Claims 1 and 2, **characterized in that** the width (B) of the shielding element (10) in the axial direction (A) on the front cap (3) is at least factor 0.25 of the height (H), wherein the height (H) is formed by the distance of the second secondary coil (8b) from the inner surface (3.1) of the front cap (3), the width (B) is ideally in the range of factor 0.3 to 0.5 of the height (H).

4. Proximity sensor (1) according to any one of the preceding claims, **characterized in that** the shielding element (10) bears at least in sections on the
- inner wall (2.1) of the housing (2) and/or
- inner cap wall (3.2)
surrounding the second secondary coil (8b) or the pair consisting of second secondary coil (8b) and primary coil (7).

5. Proximity sensor (1) according to any one of the preceding claims, **characterized in that** the shielding ring (10) bears on the inside of the front cap (3), and wherein the diameter of the second secondary coil (8b) is a factor of 0.6 to 0.7 of the diameter of the shielding element (10).

6. Proximity sensor (1) according to any one of the preceding claims, **characterized in that** at least one non-metallic, single-part or multi-part spacer body (11) is arranged between the inner surface (3.1) of the front cap (3) and the shielding element (10), wherein the shielding element (10) rests on this spacer body (11) at least in sections and/or is carried thereby.

7. Proximity sensor (1) according to any one of the preceding claims, **characterized in that** the spacer body is a ring or an annulus, in particular a plastic ring or annulus.

8. Proximity sensor (1) according to any one of the preceding claims, **characterized in that** that the coil carrier (6) is annular and has an inner wall (6.2), wherein a carrier element (12) is provided, to which the printed circuit board (4) is attached, and the carrier element (12) bears by way of a guiding and holding portion (12.1) against the inner wall (6.2) of the coil carrier (6) and/or is attached thereto.

9. Proximity sensor (1) according to any one of the preceding claims, **characterized in that** the printed circuit board (4) is connected to a plug element (9) or comprises a plug element (9), via which the proximity sensor (1) can be connected to external structures so as to conduct data and/or current.

10. Proximity sensor (1) according to Claim 9, **characterized in that** the plug element (9) comprises a group of two or more individual plugs (9.1 ... 9.n) arranged next to one another, wherein the individual plugs (9.1 ... 9.n) are oriented parallel to the axis (A).

11. Proximity sensor (1) according to any one of Claims 9 and 10, **characterized in that**
- the plug element (9) bears at least in sections on the foot surface (6.3) opposite to the end surface (6.1) of the coil carrier (6) and bypasses the annular coil carrier (6), or
- the plug element (9) bears on or is attached to a web element (12.2) of the carrier element (12), which web element bears at least in sections on the foot surface (6.1) of the coil carrier (6) and bypasses the annular coil carrier (6).

## Revendications

1. Capteur de proximité (1) pour la détection inductive d'objets (50), comprenant
- un boîtier (2) comportant un capuchon frontal (3) qui forme le côté de détection du capteur de proximité (1),
- une unité (5) de traitement et de réception comprenant une carte à circuit imprimé (4), qui est apte à être reliée à une unité externe (100) de commande et/ou d'évaluation,
- un support de bobine (6) en une ou plusieurs parties est prévu, sur lequel au moins une bobine primaire (7) et au moins une première bobine secondaire (8a) sont agencées, en étant enroulées ou imprimées en continu à distance l'une de l'autre dans la direction de l'axe (A), une face frontale (6.1) du support de bobine (6) étant située directement en face de la surface intérieure (3.1) du capuchon frontal (3) et/ou en contact avec celle-ci, et la première bobine secondaire (8a) étant plus proche de la face frontale (6.1) dans le sens axial que la bobine primaire (7), une deuxième bobine secondaire (8b) étant prévue sur le support de bobine (6), laquelle est enroulée dans le sens opposé à la première bobine secondaire (8a), la bobine primaire (7) étant agencée entre les deux bobines secondaires (8a, b), un élément de blindage métallique (10) étant agencé de manière à entourer la deuxième bobine secondaire (8b), et l'élément de blindage (10) ne dépassant pas dans la zone axiale de la première bobine secondaire (8a) de façon à ne pas restreindre le rayon de détection de celle-ci.

2. Capteur de proximité (1) selon la revendication 1, **caractérisé en ce que** l'élément de blindage (10) comprend une largeur telle que la bobine primaire (7) est également au moins partiellement blindée dans la direction axiale, en particulier complètement blindée.

3. Capteur de proximité (1) selon l'une des revendications 1 ou 2, **caractérisé en ce que** la largeur (B) de l'élément de blindage (10) dans la direction axiale (A) sur le capuchon frontal (3) est d'au moins 0,25 fois la hauteur (H), la hauteur (H) étant définie par la distance entre la deuxième bobine secondaire (8b) et la surface intérieure (3.1) du capuchon frontal (3), la largeur (B) étant de préférence comprise entre 0,3 et 0,5 fois la hauteur (H).

4. Capteur de proximité (1) selon l'une des revendications précédentes, **caractérisé en ce que** l'élément de blindage (10), au niveau de la deuxième bobine secondaire (8b) ou la paire constituée par la deuxième bobine secondaire (8b) et la bobine primaire (7), est au moins partiellement en contact
- avec la paroi intérieure (2.1) du boîtier (2), qu'il entoure, et/ou
- avec la paroi intérieure du capuchon (3.2), qu'il entoure.

5. Capteur de proximité (1) selon l'une des revendications précédentes, **caractérisé en ce que** l'anneau de blindage (10) est en contact avec la face intérieure du capuchon frontal (3), le diamètre de la deuxième bobine secondaire (8b) étant compris entre 0,6 et 0,7 fois le diamètre de l'élément de blindage (10).

6. Capteur de proximité (1) selon l'une des revendications précédentes, **caractérisé en ce qu'**au moins un élément d'espacement (11) non métallique, en une ou plusieurs parties, est agencé entre la surface intérieure (3.1) du capuchon frontal (3) et l'élément de blindage (10), l'élément de blindage (10) reposant au moins partiellement sur cet élément d'espacement (11) et/ou étant porté par celui-ci.

7. Capteur de proximité (1) selon l'une des revendications précédentes, **caractérisé en ce que** le corps d'espacement est un anneau ou une couronne, en particulier un anneau ou une couronne en matière plastique.

8. Capteur de proximité (1) selon l'une des revendications précédentes, **caractérisé en ce que** le support de bobine (6) est de forme annulaire et comprend une paroi intérieure (6.2), un élément de support (12) étant prévu sur lequel la carte à circuit imprimé (4) est fixée, et l'élément de support (12) est en contact et/ou fixé à la paroi intérieure (6.2) du support de bobine (6) par une partie de guidage et de maintien (12.1).

9. Capteur de proximité (1) selon l'une des revendications précédentes, **caractérisé en ce que** la carte à circuit imprimé (4) est reliée à un élément connecteur (9) ou comprend un élément connecteur (9) par l'intermédiaire duquel le capteur de proximité (1) est apte à être relié à des structures externes de manière à transmettre des données et/ou du courant.

10. Capteur de proximité (1) selon la revendication 9, **caractérisé en ce que** l'élément connecteur (9) comprend un groupe de deux connecteurs individuels (9.1... 9.n) ou plus agencés côte à côte, les connecteurs individuels (9.1... 9.n) étant orientés parallèlement à l'axe (A).

11. Capteur de proximité (1) selon l'une des revendications 9 ou 10, **caractérisé en ce que**
- l'élément connecteur (9) repose au moins partiellement sur la surface de base (6.3) opposée à la surface frontale (6.1) du support de bobine (6) et enjambe le support de bobine annulaire (6) ou
- l'élément connecteur (9) repose sur un élément de traverse (12.2) de l'élément de support (12) ou y est fixé, lequel repose au moins partiellement sur la surface d'appui (6.1) du porte-bobine (6) et enjambe le porte-bobine annulaire (6).
